# FASCICULE DE BREVET EUROPEEN

(11) **EP 3 073 280 B1**
(45) Date de publication et mention de la délivrance du brevet: **18.12.2019**
(21) Numéro de dépôt: 16158167.3
(22) Date de dépôt: 02.03.2016
(51) Int. Cl.: G01R 31/3177, G01R 31/3185, G01R 31/319, G01R 31/317

(54) **TESTEUR DE CIRCUITS INTÉGRÉS SUR UNE GALETTE DE SILICIUM ET CIRCUIT INTÉGRÉ**
TESTER FÜR INTEGRIERTE SCHALTKREISE AUF EINEM SILIZIUM-WAFER, UND INTEGRIERTER SCHALTKREIS
TESTER OF INTEGRATED CIRCUITS ON A SILICON WAFER, AND INTEGRATED CIRCUIT

(30) Priorité: 06.03.2015 FR 1551904
(43) Date de publication de la demande: 28.09.2016
(73) Titulaire: Starchip, 13590 Meyreuil (FR)
(72) Inventeur: LAMBERT, Cyrille, 13590 MEYREUIL (FR); BAYON, Sébastien, 13590 MEYREUIL (FR); CROGUENNEC, Alexandre, 13590 MEYREUIL (FR)
(74) Mandataire: Cabinet Le Guen Maillet

(56) Documents cités:
- US-A1- 2004 054 951
- US-A1- 2007 216 438
- US-A1- 2010 100 786

## Description

La présente invention concerne un procédé et un dispositif de test de circuits intégrés disposés sur une galette de silicium.

Les circuits intégrés sont fabriqués sur des galettes de silicium (en anglais wafer). Une galette de silicium comporte un grand nombre de circuits intégrés, typiquement des milliers. Les testeurs utilisés pour tester les circuits intégrés comportent une quantité limitée de connexions entrée/sortie avec la galette de silicium qui ne peut être augmentée.

Pour tester tous les circuits intégrés sur une galette de silicium, le testeur entre en contact à l'aide d'une carte à pointe (en anglais probe card) avec des zones rectangulaires du circuit intégré plusieurs fois pour établir une liaison électrique avec le circuit intégré. Plusieurs circuits intégrés sont testés simultanément afin de réduire le temps du test de la galette de silicium.

Plus le nombre de circuits intégrés testés en parallèle est grand, plus le temps de test de la galette de silicium est court. Plus le nombre de pointes de test utilisées pour tester un circuit intégré est important, moins le nombre de circuits intégrés testés en parallèle est important du fait de la limitation imposée par le nombre de connexions entrée/sortie et de pointes de test du testeur.

De plus, les circuits intégrés sur les galettes de silicium ont une horloge interne dont la fréquence varie d'une manière importante d'un circuit intégré à l'autre. Il en résulte une difficulté non négligeable dans le test des circuits intégrés.

La demande de brevet US 2007/0216438 divulgue un testeur de circuits intégrés.

La présente invention a pour but de résoudre les inconvénients de l'art antérieur en proposant un procédé et un dispositif de test dans lequel une seule connexion entrée/sortie est nécessaire au test d'un circuit intégré dont la fréquence de l'horloge interne n'est pas connue du testeur.

A cette fin, selon un premier aspect, l'invention propose un testeur de circuits intégrés présents sur une galette de silicium caractérisé en ce que le testeur comporte une connexion entrée sortie pour tester un circuit intégré et en ce que le testeur comporte :
- des moyens de transfert au circuit intégré d'une trame de données par la connexion entrée sortie, la trame de données comportant une référence de temps pour les données comprises dans la trame de données, un champ de validation de la référence de temps et un champ de données comprenant au moins une commande de test du circuit intégré,
- des moyens de réception, par la connexion entrée sortie, d'une trame de données, les données de la trame de données reçue ayant une durée multiple de la référence de temps.

La présente invention concerne aussi un procédé de test, par un testeur de circuits intégrés présents sur une galette de silicium, le testeur comportant une connexion entrée sortie pour tester un circuit intégré, caractérisé en ce que le procédé comporte les étapes de :
- transfert au circuit intégré d'une trame de données par la connexion entrée sortie, la trame de données comportant une référence de temps pour les données comprises dans la trame de données, un champ de validation de la référence de temps et un champ de données comprenant au moins une commande de test du circuit intégré,
- réception, par la connexion entrée sortie, d'une trame de données, les données de la trame de données reçue ayant une durée multiple de la référence de temps.

Ainsi, en n'utilisant qu'une connexion entrée sortie en sus de connexions d'alimentation du circuit intégré pour le test du circuit intégré, le nombre de circuits intégrés testés en parallèle est augmenté. Le temps de test des circuits intégrés d'une galette de silicium est réduit et le coût de production des circuits intégrés est réduit même si la fréquence de l'horloge interne des circuits intégrés n'est pas connue du testeur.

En insérant une référence de temps dans la trame de données transmise, les circuits intégrés peuvent se synchroniser avec les données reçues et peuvent traiter celles-ci. Il n'est alors plus nécessaire d'avoir une connexion dédiée à la transmission d'une horloge commune aux circuits intégrés et au testeur.

Les données de la trame de données reçue ayant une durée multiple de la référence de temps, les contraintes telles que les fronts de montées, de descentes des signaux transmis par le circuit intégré sont moindres. Les caractéristiques des éléments électroniques, par exemple en termes de capacité à fournir du courant peuvent être réduites comme l'encombrement de ces éléments électroniques. Le coût du circuit intégré se trouve ainsi aussi réduit.

Selon un mode particulier de l'invention, chaque donnée de la trame de données transférée au circuit intégré est représentée par un niveau logique haut et bas.

Ainsi, le circuit intégré peut continuer à se synchroniser pendant la réception des données.

Selon un mode particulier de l'invention, la trame de données transférée au circuit intégré comporte en outre une valeur associée à la commande de test du circuit intégré.

Ainsi, le testeur peut faire varier certains paramètres pour le test des circuits intégrés.

Selon un mode particulier de l'invention, la commande de test du circuit intégré est une commande d'ajustement d'une valeur analogique ou fréquentielle ou numérique dans le circuit intégré.

Ainsi, une seule connexion entrée sortie est utilisée pour le test d'un circuit intégré, le nombre de circuits intégrés testés en parallèle est augmenté.

Selon un mode particulier de l'invention, la commande est une commande de transmission ou de réception d'un signal analogique dans une fenêtre temporelle suivant la trame de données et le testeur comporte des moyens de transmission ou de réception du signal analogique dans la fenêtre temporelle suivant la trame de données.

Ainsi, une seule connexion entrée sortie est utilisée pour le test d'un circuit intégré, le nombre de circuits intégrés testés en parallèle est augmenté.

Selon un mode particulier de l'invention, la commande est une commande d'ajustement de l'horloge interne du circuit intégré ou une commande d'ajustement d'une tension d'écriture ou d'effacement d'une donnée dans une mémoire du circuit intégré.

Ainsi, tous les ajustements nécessaires aux circuits intégrés pour un fonctionnement selon les critères d'un cahier des charges peuvent être réalisés.

La présente invention concerne aussi un circuit intégré caractérisé en ce qu'il comporte une connexion entrée sortie pour le test du circuit intégré et en ce qu'il comporte :
- des moyens de réception d'une trame de données par la connexion entrée sortie, la trame de données comportant une référence de temps pour les données comprises dans la trame de données, un champ de validation de la référence de temps et un champ de données comprenant au moins une commande de test du circuit intégré,
- des moyens de transfert, par la connexion entrée sortie, d'une trame de données, les données de la trame de données transférée ayant une durée multiple de la référence de temps.

La présente invention concerne aussi un procédé de test d'un circuit intégré comportant une connexion entrée sortie pour le test du circuit intégré, caractérisé en ce que le procédé comporte les étapes effectuées par le circuit intégré de :
- réception d'une trame de données par la connexion entrée sortie, la trame de données comportant une référence de temps pour les données comprises dans la trame de données, un champ de validation de la référence de temps et un champ de données comprenant au moins une commande de test du circuit intégré,
- transfert par la connexion entrée sortie, d'une trame de données, les données de la trame de données transférée ayant une durée multiple de la référence de temps.

Ainsi, en se synchronisant sur la référence de temps dans la trame de données transmise, le circuit intégré peut traiter les données reçues.

De plus, le nombre de pointes maximum d'une carte à pointe étant limité par les capacités technologiques, l'augmentation du nombre de puces testées en parallèle permet de réduire le coût du test. La présente invention permet d'optimiser au maximum l'utilisation de la carte à pointes.

De plus, le coût de production des circuits intégrés est réduit même si la fréquence de l'horloge interne des circuits intégrés n'est pas connue du testeur.

Les données de la trame de données émise ayant une durée multiple de la référence de temps, les contraintes telles que les fronts de montées, de descentes des signaux transmis par le circuit intégré sont moindres. Les caractéristiques des éléments électroniques, par exemple en termes de capacité à fournir du courant peuvent être réduites comme l'encombrement de ces éléments électroniques. Le coût du circuit intégré se trouve ainsi aussi réduit.

Selon un mode particulier de l'invention, la trame de données reçue comporte en outre une valeur associée à la commande de test du circuit intégré.

Ainsi, les différentes valeurs nécessaires au test du circuit intégré n'ont pas besoin d'être mémorisées dans celui-ci. L'encombrement du circuit intégré s'en trouve réduit.

Selon un mode particulier de l'invention, la commande de test du circuit intégré est une commande d'ajustement d'une valeur analogique ou fréquentielle ou numérique dans le circuit intégré.

Ainsi, une seule connexion entrée sortie est utilisée pour le test d'un circuit intégré, le nombre de circuits intégrés testés en parallèle est augmenté.

Selon un mode particulier de l'invention, la commande est une commande de transmission ou de réception d'un signal analogique dans une fenêtre temporelle suivant la trame de données et le circuit intégré comporte des moyens de transmission ou de réception du signal analogique dans la fenêtre temporelle suivant la trame de données.

Ainsi, une seule connexion entrée sortie est utilisée pour le test d'un circuit intégré, le nombre de circuits intégrés testés en parallèle est augmenté.

Selon un mode particulier de l'invention, la commande est une commande d'ajustement de l'horloge interne du circuit intégré.

Ainsi, la fréquence de l'horloge interne du circuit intégré peut être ajustée à une valeur correspondant à un critère d'un cahier des charges.

Selon un mode particulier de l'invention, la commande est une commande d'ajustement d'une tension d'écriture ou d'effacement d'une donnée dans une mémoire Flash du circuit intégré.

Ainsi, tous les ajustements nécessaires aux circuits intégrés pour un fonctionnement selon les critères d'un cahier des charges peuvent être réalisés.

Selon un mode particulier de l'invention, à la réception de la commande d'ajustement de la tension d'écriture ou d'effacement, le circuit intégré commande des moyens de lecture dans une mémoire du circuit intégré à l'aide d'une machine d'état pour ajuster la tension d'écriture ou d'effacement.

Ainsi, le circuit intégré est apte à ajuster des paramètres de manière autonome sans échanger des données avec le testeur. Le temps de test est ainsi réduit.

L'invention concerne aussi les programmes d'ordinateur stockés sur un support d'informations, lesdits programmes comportant des instructions permettant de mettre en œuvre les procédés précédemment décrits, lorsqu'ils sont chargés et exécutés par un système informatique.

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :
la Fig. 1 représente un système de test de circuits intégré sur galette de silicium ;
la Fig. 2 représente une architecture de dispositif de test selon la présente invention ;
la Fig. 3 représente une architecture de circuit intégré sur une galette de silicium selon la présente invention ;
la Fig. 4 représente un exemple de trame de données émise par le testeur et à destination de circuits intégrés ;
la Fig. 5 représente un exemple de trame de données émise par un circuit intégré et à destination du testeur ;
la Fig. 6 représente des exemples de commandes comprises dans une trame telle que décrite en référence à la Fig. 4 ;
la Fig. 7 représente un algorithme de test exécuté par le testeur selon la présente invention ;
la Fig. 8 représente un algorithme de test exécuté par un circuit intégré selon la présente invention ;
la Fig. 9 représente un algorithme exécuté par un circuit intégré à réception d'une commande d'ajustement de la tension de programmation ou d'effacement d'une mémoire Flash.

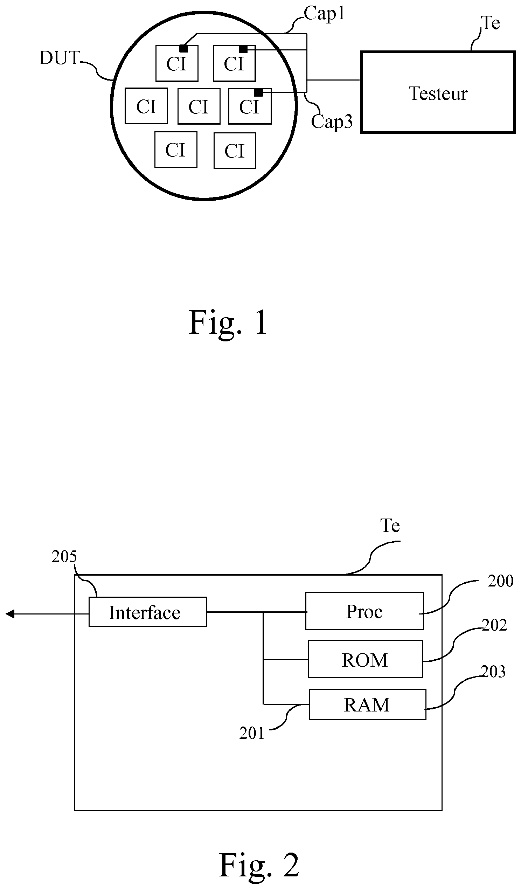

La **Fig. 1** représente un système de test de circuits intégré sur galette de silicium.

Dans la Fig. 1 un testeur Te teste les circuits intégrés CI d'une galette de silicium DUT à l'aide d'une pluralité de cartes à pointe venant en contact des zones rectangulaires d'un groupe de circuits intégrés qui sont testés en parallèle.

Le testeur Te est par exemple un ordinateur qui pilote une ou plusieurs cartes à pointes. Le testeur Te teste si les circuits intégrés sont conformes à un cahier des charges et permet l'ajustement de paramètres des circuits intégrés.

Selon la présente invention, chaque circuit intégré dispose d'une unique zone de contact représentée par un carré noir dans la Fig. 1 qui est utilisée pour le test du circuit intégré. Une seule pointe est utilisée par le testeur Te pour tester un circuit intégré en sus des pointes d'alimentation des circuits intégrés. Lorsqu'une pointe est en contact avec la zone de contact, une connexion entrée sortie est réalisée selon la présente invention.

Dans la Fig. 1, trois circuits intégrés sont testés en parallèle à l'aide d'une carte à pointe comportant les pointes Cap1 à Cap3. Bien entendu, un nombre plus important de circuits intégrés sont testés en parallèle, l'exemple de la Fig. 1 n'étant qu'une simplification de conditions réelles.

De même, seulement sept circuits intégrés sont représentés dans la Fig. 1 par souci de simplification. Bien entendu, un nombre plus important de circuits intégrés sont présents sur la galette de silicium DUT.

Chaque circuit intégré dispose de sa propre horloge interne dont la fréquence varie d'un circuit intégré à l'autre et est différente de celle du testeur Te.

L'utilisation d'une unique zone de contact selon la présente invention est possible grâce à un protocole de communication entre le testeur Te et chaque circuit intégré CI est testé de manière à ce que le testeur Te puisse indiquer le type de test ou réglage qui doit être effectué et que le circuit intégré CI le comprenne. Il en est de même pour l'échange d'informations entre le circuit intégré CI et le testeur Te.

Dans le test d'un circuit intégré, des signaux à la fois numériques et analogiques sont échangés entre le circuit intégré CI et le testeur Te. Par exemple l'ajustement de paramètres de la mémoire Flash du circuit intégré CI, la sélection de certains modes de test de la mémoire Flash, permettent de mesurer des tensions et/ou des courants électriques. L'utilisation d'une unique zone de contact selon la présente invention pour le test d'un circuit intégré CI prend en compte cette contrainte.

Selon la présente invention, le testeur Te comporte :
- des moyens de transfert au circuit intégré d'une trame de données par la connexion entrée sortie, la trame de données comportant une référence de temps pour les données comprises dans la trame de données, un champ de validation de la référence de temps et un champ de données comprenant au moins une commande de test du circuit intégré,
- des moyens de réception, par la connexion entrée sortie, d'une trame de données, les données de la trame de données reçue ayant une durée multiple de la référence de temps.

Chaque circuit intégré comporte :
- des moyens de réception d'une trame de données par la connexion entrée sortie, la trame de données comportant une référence de temps pour les données comprises dans la trame de données, un champ de validation de la référence de temps et un champ de données comprenant au moins une commande de test du circuit intégré,
- des moyens de transfert, par la connexion entrée sortie, d'une trame de données, les données de la trame de données transférée ayant une durée multiple de la référence de temps.

La **Fig. 2** représente une architecture de dispositif de test ou testeur selon la présente invention.

Le testeur Te comprend :
- un processeur, micro-processeur, ou microcontrôleur 200 ;
- une mémoire volatile 203 ;
- une mémoire ROM 202;
- une interface 205 qui comporte au moins une carte à pointe ;
- un bus de communication 201 reliant le processeur 200 à la mémoire ROM 202, à la mémoire RAM 203 et à l'interface 205.

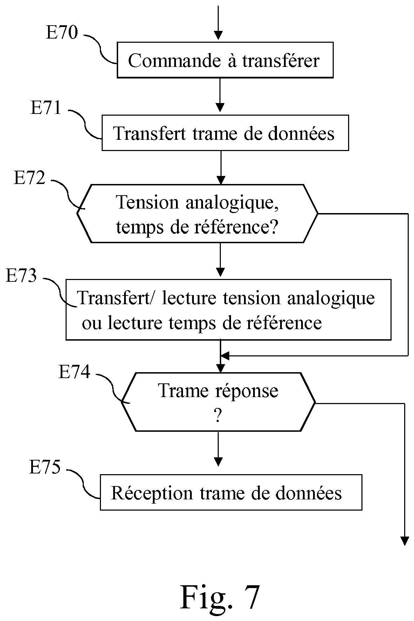

Le processeur 200 est capable d'exécuter des instructions chargées dans la mémoire volatile 203 à partir de la mémoire ROM 202, d'une mémoire externe (non représentée), d'un support de stockage. Lorsque le testeur Te est mis sous tension, le processeur 200 est capable de lire de la mémoire volatile 203 des instructions et de les exécuter. Ces instructions forment un programme d'ordinateur qui cause la mise en œuvre, par le processeur 200, de tout ou partie du procédé décrit en relation avec la Fig. 7.

Tout ou partie du procédé décrit en relation avec la Fig. 7 peut être implémenté sous forme logicielle par exécution d'un ensemble d'instructions par une machine programmable, telle qu'un DSP (*Digital Signal Processor* en anglais ou *Unité de Traitement de Signal Numérique* en français) ou un microcontrôleur ou être implémenté sous forme matérielle par une machine ou un composant dédié, tel qu'un FPGA (*Field-Programmable Gate Array* en anglais ou *Matrice de Portes Programmable sur le Terrain* en français) ou un ASIC (*Application-Specific Integrated Circuit* en anglais ou *Circuit Intégré Spécifique à une Application* en français).

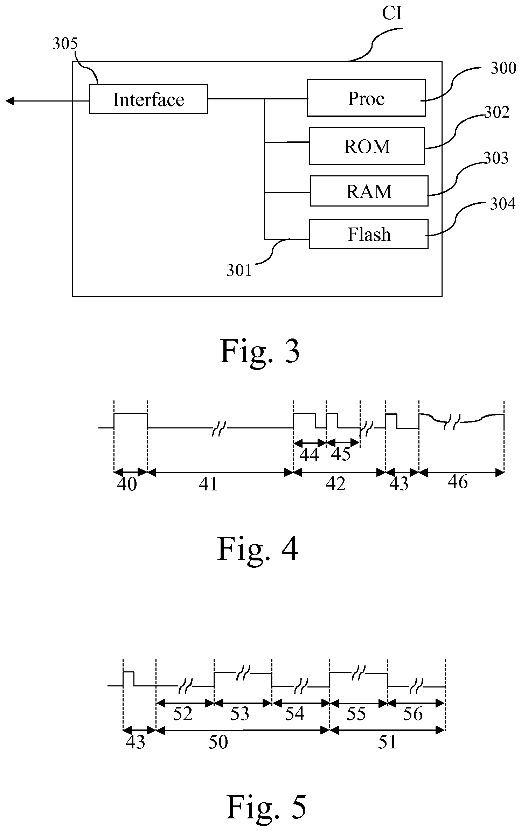

La **Fig. 3** représente une architecture de circuit intégré sur une galette de silicium selon la présente invention.

Le circuit intégré Te comprend :
- un processeur, micro-processeur, ou microcontrôleur 300 ;
- une mémoire volatile 303 ;
- une mémoire ROM 302 ;
- une mémoire Flash 304 ;
- une interface 305 qui comporte une zone de contact pour un contact avec une pointe d'une carte à pointe;
- un bus de communication 301 reliant le processeur 300 à la mémoire ROM 302, à la mémoire RAM 303, à la mémoire Flash 304 et à l'interface 305.

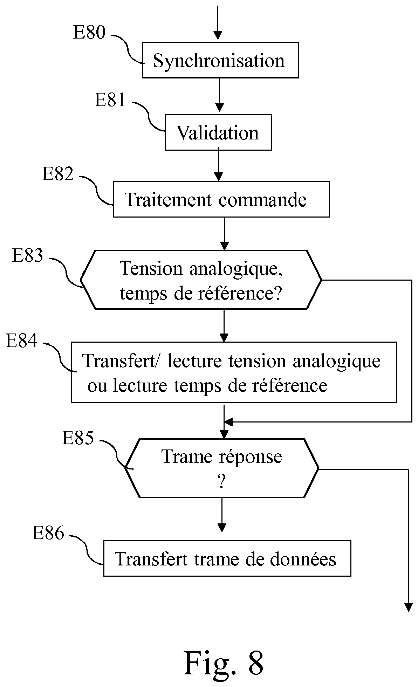

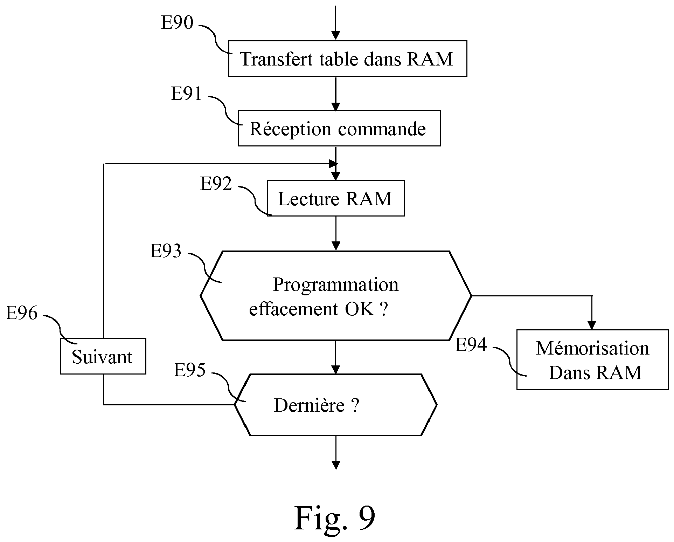

Le processeur 300 est capable d'exécuter des instructions chargées dans la mémoire volatile 303 à partir de la mémoire ROM 302. Lorsque le circuit intégré CI est mis sous tension, le processeur 300 est capable de lire de la mémoire volatile 303 des instructions et de les exécuter. Ces instructions forment un programme d'ordinateur qui cause la mise en œuvre, par le processeur 300, de tout ou partie des procédés décrits en relation avec les Figs. 8 et 9.

Tout ou partie des procédés décrits en relation avec les Figs. 8 et 9 peut être implémenté sous forme logicielle par exécution d'un ensemble d'instructions par une machine programmable, telle qu'un DSP (*Digital Signal Processor* en anglais ou *Unité de Traitement de Signal Numérique* en français) ou un microcontrôleur ou être implémenté sous forme matérielle par une machine ou un composant dédié.

La **Fig. 4** représente un exemple de trame de données émise par le testeur et à destination de circuits intégrés.

La trame de données émise par le testeur Te et à destination de circuits intégrés CI se décompose en une référence de temps 40, un champ de validation de la référence de temps 41, de données 42 et d'une fin de trame 43.

Le testeur Te envoie des commandes aux circuits intégrés CI et reçoit éventuellement des réponses aux commandes envoyées.

Selon le protocole utilisé, une auto calibration est effectuée au moins à chaque début de trame émise par le testeur Te. La référence de temps 40 a une durée déterminée par la fréquence du testeur Te. La référence 40 correspond par exemple à un niveau logique haut dont la durée est par exemple égale à trois périodes d'horloge de l'horloge du testeur Te. Cette durée de trois périodes d'horloge sera utilisée par le circuit intégré CI pour se synchroniser avec l'horloge du testeur Te.

Le champ de validation de la référence de temps 41 correspond à un niveau logique bas dont la durée est par exemple égale à un nombre entier prédéterminé de fois la durée de la référence de temps 40. Par exemple, le champ de validation a une durée égale à huit fois la durée de la référence de temps 40.

Le champ de validation de la référence de temps 41 permet au circuit intégré CI recevant la trame de données de vérifier si la référence de temps correspond effectivement à un début de trame ou non. Si le champ de validation de la référence de temps 41 n'est pas égal au nombre prédéterminé de fois la durée de la référence de temps 40, la référence de temps 40 est une impulsion parasite. Si le champ de validation de la référence de temps 41 est égal au nombre prédéterminé de fois la durée de la référence de temps 40, une trame est effectivement reçue.

Le champ de données 42 contient les données nécessaires à la commande envoyée.

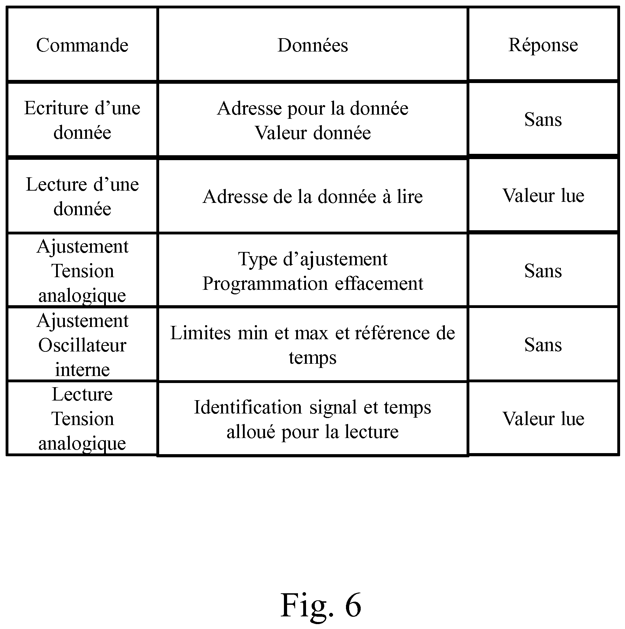

Des exemples de commandes sont donnés en référence à la Fig. 6.

Le champ de données 42 comporte une succession de valeur binaires « 0 » ou « 1 ».

Par exemple, la valeur binaire « 1 » dans le champ 44 correspond à deux périodes d'horloge de l'horloge du testeur Te au niveau haut suivies d'une période d'horloge de l'horloge du testeur Teau niveau bas.

Par exemple, la valeur binaire « 0 » dans le champ 45 correspond à une période d'horloge de l'horloge du testeur Te au niveau haut suivie de deux périodes d'horloge de l'horloge du testeur Te au niveau bas.

Selon cet exemple, le circuit intégré CI peut, pendant la réception des données continuer à se synchroniser sur l'horloge du testeur Te.

En variante, la valeur binaire « 1 » correspond à trois périodes d'horloge de l'horloge du testeur Te au niveau haut et la valeur binaire « 0 » correspond à trois périodes d'horloge de l'horloge du testeur Te au niveau bas.

La fin de trame 43 correspond à deux périodes d'horloge de l'horloge du testeur Te au niveau haut suivies d'une période d'horloge de l'horloge du testeur Te au niveau bas.

Après la fin de trame 43, pendant une durée notée 46, une tension analogique peut être éventuellement transmise ou reçue. Cette tension analogique est délivrée par le circuit intégré CI ou par le testeur Te. Cette tension analogique est par exemple une tension fournie par le testeur Te par l'intermédiaire d'une commande présente dans le champ de données ou une tension demandée par le testeur Te par l'intermédiaire d'une commande présente dans le champ de données.

La durée 46 peut aussi être une référence de temps.

La **Fig. 5** représente un exemple de trame de données émise par un circuit intégré et à destination du testeur.

Dès la réception d'une fin de trame 43, le circuit intégré CI répond si besoin à la trame telle que décrite en référence à la Fig. 4.

La Fig. 5 représente une fin de trame 43 pour une réponse numérique de la trame telle que décrite en référence à la Fig. 4, un début de trame 50 et un champ données 51.

La trame comporte un début de trame 50. Le début de trame 50 comprend trois valeurs binaires 52 à 54.

L'horloge utilisée par le circuit intégré CI est un nombre entier de fois la durée du champ de démarrage 40 de la trame telle que décrite en référence à la Fig. 4 et supérieure ou égale à deux fois la durée du champ de démarrage 40.

Par exemple, le nombre de fois est un multiple de deux, préférentiellement égal à huit.

En effet, le circuit intégré CI devant avoir une surface silicium la plus faible possible, l'étage de sortie délivrant les trames de données au testeur Te a des spécifications en terme de fourniture de courant bien moindre que l'étage de sortie du testeur Te. En utilisant un multiple de la durée du champ de démarrage 40, les éventuels problèmes liés aux limitations liées au courant de sortie sont résolus. De plus, de par la disparité des fréquences internes des circuits intégrés, la durée d'une information binaire pour le transfert de trame du circuit intégré CI est choisie d'une telle manière que tous les circuits intégrés fonctionnels puissent répondre à un rythme approprié.

La valeur binaire 52 est au niveau bas « 0 » et a une durée de huit fois la durée du champ de démarrage 40.

La valeur binaire 52 est au niveau haut « 1 » et a une durée de huit fois la durée du champ de démarrage 40.

La valeur binaire 53 est au niveau bas « 0 » et a une durée de huit fois la durée du champ de démarrage 40.

Le champ données 51 comprend une ou plusieurs valeurs binaires.

Dans l'exemple de la Fig. 5, le champ données comprend deux valeurs binaires 55 et 56.

La valeur binaire 55 est au niveau bas « 0 » et a une durée de huit fois la durée du champ de démarrage 40.

La valeur binaire 56 est au niveau haut « 1 » et a une durée de huit fois la durée du champ de démarrage 40.

La trame émise par le circuit intégré CI ne comporte pas de délimiteur de fin de trame. Ceci n'est pas utile car le testeur Te sait si une réponse est nécessaire ou non ainsi que le nombre de bits dans l'affirmative.

La **Fig. 6** représente des exemples de commandes comprises dans une trame telle que décrite en référence à la Fig. 4.

La table de la Fig. 6 comporte trois colonnes, une première colonne indique le type de commande. Le type de commande, sous la forme d'un mot binaire prédéterminé, est inclus dans le champ données 42 de la trame telle que décrite en référence à la Fig. 4.

La seconde colonne indique les données qui sont comprises dans le champ données 42.

La troisième colonne indique si une réponse telle que décrite en référence à la Fig. 5 ou pendant la durée notée 46 en Fig. 6 doit ou non être transmise par le circuit intégré CI. Cette réponse est, suivant le type de commande, numérique, analogique ou fréquentielle.

Pour un commande d'écriture de données, le champ données 42 comprend l'adresse à laquelle la donnée doit être écrite ainsi que la valeur de la donnée. Aucune trame ne doit être transmise en réponse.

Pour un commande de lecture de données, le champ données 42 comprend l'adresse à laquelle la donnée doit être lue et retournée dans le champ données 51 de la Fig. 5.

Une trame telle que décrite en référence à la Fig. 5 doit être transmise en réponse. Le champ 51 de la trame comprend la valeur de la donnée lue.

Pour une commande d'ajustement de tension analogique, le champ données 42 comprend le type d'ajustement à effectuer comme par exemple une tension de programmation ou d'effacement. Aucune trame ne doit être transmise en réponse.

Préalablement à la commande d'ajustement de tension analogique, une table de paramètres est écrite dans une zone prédéterminée d'une mémoire du circuit intégré. La mémoire est par exemple une mémoire RAM.

Pour une commande d'ajustement de l'oscillateur interne du circuit intégré, le champ données 42 comprend la plage de valeur dans laquelle la fréquence de l'oscillateur interne du circuit intégré doit être ajustée. Une référence de temps est insérée dans le champ 46 de la Fig. 4. Aucune trame ne doit être transmise en réponse.

Le circuit intégré CI, à la réception de la commande d'ajustement de l'oscillateur interne, compte le nombre d'impulsions produites par l'oscillateur interne pendant la référence de temps indiquée par la durée du champ 46. Si le nombre d'impulsions comptées n'est pas compris dans la plage de valeur, la fréquence de l'oscillateur interne est modifiée jusqu'à ce que le nombre d'impulsions comptées soit compris dans la plage de valeur.

Pour une commande de lecture d'une tension analogique, le champ données 42 comprend une information indiquant quel signal analogique le testeur Te va insérer dans le champ 46 de la Fig. 4 ainsi que la durée du champ 46.

La **Fig. 7** représente un algorithme de test exécuté par le testeur selon la présente invention.

Plus précisément, le présent algorithme est exécuté par le processeur 200 du testeur Te.

A l'étape E70 le processeur 200 sélectionne une commande à envoyer à au moins un circuit intégré CI parmi une liste de commandes correspondant à des tests ou des ajustements des paramètres des circuits intégrés CI.

A l'étape suivante E71, le processeur 200 commande le transfert de la trame de données telle que décrite en référence à la Fig. 4 et qui comprend la commande sélectionnée.

A l'étape suivante E72, le processeur 200 vérifie si, pour la commande, une tension analogique doit être transmise ou reçue ou un temps de référence est compris dans le champ 46 de la Fig. 4.

Dans l'affirmative, le processeur 200 passe à l'étape E73 et transfère ou lit la tension analogique ou le temps de référence pendant la durée notée 46 en Fig. 4. Dans la négative, le processeur 200 passe à l'étape E74.

A l'étape E74, le processeur 200 vérifie si une trame doit être reçue en réponse à la trame transmise à l'étape E71.

Si une trame doit être reçue en réponse à la trame transmise à l'étape E71, le processeur 200 passe à l'étape E75. Dans la négative, le processeur 200 interrompt le présent algorithme.

A l'étape E75, le processeur 200 reçoit par l'intermédiaire de l'interface 205 la trame de données telle que décrite en référence à la Fig. 5.

Cette opération effectuée, le processeur 200 interrompt le présent algorithme.

La **Fig. 8** représente un algorithme de test exécuté par un circuit intégré selon la présente invention.

Plus précisément, le présent algorithme est exécuté par le processeur 300 de chaque circuit intégré CI.

A l'étape E80, le processeur 300 reçoit une trame de données telle que décrite en référence à la Fig. 4. A cette étape, le processeur 300 se synchronise sur la référence de temps 40.

A l'étape E81, le processeur 300 valide la référence de temps en vérifiant si le champ de validation de la référence de temps 41 est égal à un nombre de fois prédéterminé la référence de temps 40. Dans la négative, le processeur 300 interrompt le présent algorithme en attente d'une nouvelle référence de temps 40.

A l'étape E82, le processeur 300 traite les données comprises dans le champ de données 42 et exécute la commande.

A l'étape suivante E83, le processeur 300 vérifie si, pour la commande, une tension analogique ou un temps de référence doit être transmise ou reçue ou transmis et reçu.

Dans l'affirmative, le processeur 300 passe à l'étape E84 et transfère ou lit une tension analogique ou mesure le temps de référence pendant la durée notée 46 en Fig. 4. Dans la négative, le processeur 300 passe à l'étape E85.

A l'étape E85, le processeur 300 vérifie si une trame de données doit être transmise en réponse à la trame de données reçue à l'étape E80.

Si une trame de données doit être transmise, le processeur 300 passe à l'étape E86. Dans la négative le processeur 300 interrompt le présent algorithme.

A l'étape E86, le processeur 300 transfère par l'intermédiaire de l'interface 305 la trame de données telle que décrite en référence à la Fig. 5.

Cette opération effectuée, le processeur 300 interrompt le présent algorithme.

La **Fig. 9** représente un algorithme exécuté par un circuit intégré à réception d'une commande d'ajustement de la tension de programmation ou d'effacement d'une mémoire Flash.

Plus précisément, le présent algorithme ou machine d'état est exécuté par le processeur 300 de chaque circuit intégré CI.

A l'étape E91, le processeur 300 commande le transfert d'une table comportant différentes valeurs de tension dans la mémoire vive RAM.

A l'étape suivante E91, le processeur 300 détecte la réception d'une commande d'ajustement de la tension de programmation ou d'effacement d'une mémoire. La mémoire est par exemple une mémoire Flash ou E2PROM ou MRAM ou MLU ou CBRAM ou FeRAM.

A l'étape suivante E92, le processeur 300 lit une valeur de tension dans la mémoire vive et applique la tension lue à la mémoire.

A l'étape suivante E93, le processeur 300 vérifie si un effacement ou une programmation a correctement été effectué.

Dans l'affirmative, le processeur 300 passe à l'étape E94 et mémorise la valeur lue dans la mémoire vive RAM.

Dans la négative, le processeur 300 passe à l'étape E95 et vérifie si toutes les valeurs comprises dans la table ont été lues.

Si toutes les valeurs comprises dans la table ont été lues, le présent algorithme s'interrompt. Dans la négative, le processeur 300 passe à l'étape E96, lit une autre valeur de tension dans la mémoire vive et applique la tension lue à la mémoire Flash.

Cette opération effectuée, le processeur 300 retourne à l'étape E93.

## Revendications

1. Testeur de circuits intégrés sur une galette de silicium, **caractérisé en ce que** le testeur comporte une unique connexion entrée sortie pour tester un circuit intégré et **en ce que** le testeur comporte :
- des moyens (E71) de transfert au circuit intégré d'une trame de données par la connexion entrée sortie, la trame de données comportant une référence de temps pour les données comprises dans la trame de données, un champ de validation de la référence de temps et un champ de données comprenant au moins une commande de test du circuit intégré, la référence de temps étant égale à la durée d'un bit de données,
- des moyens (E74) de réception, par la connexion entrée sortie, d'une trame de données, les données de la trame de données reçue ayant une durée égale à un nombre entier multiple de la référence de temps et supérieure ou égale à deux fois la durée de la référence de temps.

2. Testeur selon la revendication 1, **caractérisé en ce que** les données de la trame de données reçue ont une durée égale à un nombre entier multiple de deux fois la durée de la référence de temps.

3. Testeur selon la revendication 1 ou 2, **caractérisé en ce que** chaque donnée de la trame de données transférée au circuit intégré est représentée par un niveau logique haut et bas.

4. Testeur selon l'une quelconque des revendications 1 à 3**caractérisé en ce que** la trame de données transférée au circuit intégré comporte en outre une valeur associée à la commande de test du circuit intégré.

5. Testeur selon l'une quelconque des revendications 1 à 3, **caractérisé en ce que** la commande de test du circuit intégré est une commande d'ajustement d'une valeur analogique ou fréquentielle ou numérique dans le circuit intégré.

6. Testeur selon la revendication 5, **caractérisé en ce que** la commande est une commande de transmission ou de réception d'un signal analogique dans une fenêtre temporelle suivant la trame de données et **en ce que** le testeur comporte des moyens de transmission ou de réception du signal analogique dans la fenêtre temporelle suivant la trame de données.

7. Testeur selon la revendication 5, **caractérisé en ce que** la commande est une commande d'ajustement de l'horloge interne du circuit intégré ou une commande d'ajustement d'une tension d'écriture ou d'effacement d'une donnée dans une mémoire du circuit intégré.

8. Circuit intégré, **caractérisé en ce qu'**il comporte une unique connexion entrée sortie pour le test du circuit intégré et **en ce qu'**il comporte :
- des moyens de réception d'une trame de données par la connexion entrée sortie, la trame de données comportant une référence de temps pour les données comprises dans la trame de données, un champ de validation de la référence de temps et un champ de données comprenant au moins une commande de test du circuit intégré, la référence de temps étant égale à la durée d'un bit de données,
- des moyens de transfert, par la connexion entrée sortie, d'une trame de données, les données de la trame de données transférée ayant une durée égale à un nombre entier multiple de la référence de temps et supérieure ou égale à deux fois la durée de la référence de temps.

9. Circuit intégré selon la revendication 8, **caractérisé en ce que** les données de la trame de données reçue ont une durée égale à un nombre entier multiple de deux fois la durée de la référence de temps.

10. Circuit intégré selon la revendication 8 ou 9, **caractérisé en ce que** la trame de données reçue comporte en outre une valeur associée à la commande de test du circuit intégré.

11. Circuit intégré selon la revendication 10, **caractérisé en ce que** la commande de test du circuit intégré est une commande d'ajustement d'une valeur analogique ou fréquentielle ou numérique dans le circuit intégré.

12. Circuit intégré selon la revendication 10, **caractérisé en ce que** la commande est une commande de transmission ou de réception d'un signal analogique dans une fenêtre temporelle suivant la trame de données et **en ce que** le circuit intégré comporte des moyens de transmission ou de réception du signal analogique dans la fenêtre temporelle suivant la trame de données.

13. Circuit intégré selon la revendication 10, **caractérisé en ce que** la commande est une commande d'ajustement de l'horloge interne du circuit intégré.

14. Circuit intégré selon la revendication 10, **caractérisé en ce que** la commande est une commande d'ajustement d'une tension d'écriture ou d'effacement d'une donnée dans une mémoire du circuit intégré.

15. Circuit intégré selon la revendication 14, **caractérisé en ce que** à la réception de la commande d'ajustement de la tension d'écriture ou d'effacement, le circuit intégré commande des moyens de lecture dans une mémoire du circuit intégré à l'aide d'une machine d'état pour ajuster la tension d'écriture ou d'effacement.

16. Procédé de test mis en œuvre par un testeur de circuits intégrés sur une galette de silicium, le testeur comportant une unique connexion entrée sortie pour tester un circuit intégré, **caractérisé en ce que** le procédé comporte les étapes de :
- transfert au circuit intégré d'une trame de données par la connexion entrée sortie, la trame de données comportant une référence de temps pour les données comprises dans la trame de données, un champ de validation de la référence de temps et un champ de données comprenant au moins une commande de test du circuit intégré, la référence de temps étant égale à la durée d'un bit de données,
- réception, par la connexion entrée sortie, d'une trame de données, les données de la trame de données reçue ayant une durée égale à un nombre entier multiple de la référence de temps et supérieure ou égale à deux fois la durée de la référence de temps.

17. Procédé selon la revendication 15, **caractérisé en ce que** les données de la trame de données reçue ont une durée égale à un nombre entier multiple de deux fois la durée de la référence de temps.

18. Procédé, mis en œuvre par un circuit intégré, de test du circuit intégré comportant une unique connexion entrée sortie pour le test du circuit intégré, **caractérisé en ce que** le procédé comporte les étapes de :
- réception d'une trame de données par la connexion entrée sortie, la trame de données comportant une référence de temps pour les données comprises dans la trame de données, un champ de validation de la référence de temps et un champ de données comprenant au moins une commande de test du circuit intégré, la référence de temps étant égale à la durée d'un bit de données,
- transfert par la connexion entrée sortie, d'une trame de données, les données de la trame de données transférée ayant une durée égale à un nombre entier multiple de deux fois la durée de la référence de temps.

19. Procédé selon la revendication 18, **caractérisé en ce que** les données de la trame de données reçue ont une durée égale à un nombre entier multiple de deux fois la durée de la référence de temps.

## Patentansprüche

1. Tester für integrierte Schaltungen auf einem Silizium-Wafer, **dadurch gekennzeichnet, dass** der Tester eine einzelne Eingabe-Ausgabe-Verbindung zum Testen einer integrierten Schaltung aufweist und der Tester Folgendes aufweist:
- Mittel (E71) zum Übertragen eines Datenrahmens über die Eingabe-Ausgabe-Verbindung an den integrierten Schaltkreis, wobei der Datenrahmen eine Zeitreferenz für die in dem Datenrahmen enthaltenen Daten, ein Validierungsfeld für die Zeitreferenz und ein Datenfeld aufweist, das mindestens einen Befehl zum Testen der integrierten Schaltung aufweist, wobei die Zeitdifferenz gleich der Dauer eines Datenbits ist,
- Mittel (E74) zum Empfangen eines Datenrahmens über die Eingabe-Ausgabe-Verbindung, wobei die Daten des empfangenen Datenrahmens eine Dauer haben, die gleich einem ganzzahligen Vielfachen der Zeitreferenz und größer oder gleich der doppelten Dauer der Zeitreferenz ist.

2. Tester nach Anspruch 1, **dadurch gekennzeichnet, dass** die Daten des empfangenen Datenrahmens eine Dauer haben, die gleich einem ganzzahligen Vielfachen der doppelten Dauer der Zeitreferenz ist.

3. Tester nach Anspruch 1 oder 2, **dadurch gekennzeichnet, dass** alle Daten des Datenrahmens, die an die integrierte Schaltung übertragen werden, durch einen logischen High/Low-Pegel dargestellt werden.

4. Tester nach einem der Ansprüche 1 bis 3, **dadurch gekennzeichnet, dass** der an die integrierte Schaltung übertragene Datenrahmen darüber hinaus einen Wert aufweist, der dem Befehl zum Testen der integrierten Schaltung zugeordnet ist.

5. Tester nach einem der Ansprüche 1 bis 3, **dadurch gekennzeichnet, dass** der Befehl zum Testen der integrierten Schaltung ein Befehl zum Einstellen eines analogen oder frequenziellen oder digitalen Werts in der integrierten Schaltung ist.

6. Tester nach Anspruch 5, **dadurch gekennzeichnet, dass** der Befehl ein Befehl zum Übertragen oder Empfangen eines analogen Signals in einem Zeitfenster ist, das dem Datenrahmen folgt, und dass der Tester Mittel zum Übertragen oder Empfangen des analogen Signals in dem Zeitfenster aufweist, das dem Datenrahmen folgt.

7. Tester nach Anspruch 5, **dadurch gekennzeichnet, dass** der Befehl ein Befehl zum Einstellen des internen Takts der integrierten Schaltung oder ein Befehl zum Einstellen einer Spannung zum Schreiben oder zum Löschen eines Datenelements in einem Speicher der integrierten Schaltung ist.

8. Integrierte Schaltung, **dadurch gekennzeichnet, dass** sie eine einzelne Eingabe-Ausgabe-Verbindung für den Test der integrierten Schaltung aufweist und dass sie Folgendes aufweist:
- Mittel zum Empfangen eines Datenrahmens über die Eingabe-Ausgabe-Verbindung, wobei der Datenrahmen eine Zeitreferenz für die in dem Datenrahmen enthaltenen Daten, ein Validierungsfeld für die Zeitreferenz und ein Datenfeld aufweist, das mindestens einen Befehl zum Testen der integrierten Schaltung aufweist, wobei die Zeitdifferenz gleich der Dauer eines Datenbits ist,
- Mittel zum Übertragen eines Datenrahmens über die Eingabe-Ausgabe-Verbindung, wobei die Daten des übertragenen Datenrahmens eine Dauer haben, die gleich einem ganzzahligen Vielfachen der Zeitreferenz und größer oder gleich der doppelten Dauer der Zeitreferenz ist.

9. Integrierte Schaltung nach Anspruch 8, **dadurch gekennzeichnet, dass** die Daten des empfangenen Datenrahmens eine Dauer haben, die gleich einem ganzzahligen Vielfachen der doppelten Dauer der Zeitreferenz ist.

10. Integrierte Schaltung nach Anspruch 8 oder 9, **dadurch gekennzeichnet, dass** der empfangene Datenrahmen darüber hinaus einen Wert aufweist, der dem Befehl zum Testen der integrierten Schaltung zugeordnet ist.

11. Integrierte Schaltung nach Anspruch 10, **dadurch gekennzeichnet, dass** der Befehl zum Testen der integrierten Schaltung ein Befehl zum Einstellen eines analogen oder frequenziellen oder digitalen Werts in der integrierten Schaltung ist.

12. Integrierte Schaltung nach Anspruch 10, **dadurch gekennzeichnet, dass** der Befehl ein Befehl zum Übertragen oder Empfangen eines analogen Signals in einem Zeitfenster ist, das dem Datenrahmen folgt, und dass die integrierte Schaltung Mittel zum Übertragen oder Empfangen des analogen Signals in dem Zeitfenster aufweist, das dem Datenrahmen folgt.

13. Integrierte Schaltung nach Anspruch 10, **dadurch gekennzeichnet, dass** der Befehl ein Befehl zum Einstellen des internen Takts der integrierten Schaltung ist.

14. Integrierte Schaltung nach Anspruch 10, **dadurch gekennzeichnet, dass** der Befehl ein Befehl zum Einstellen einer Spannung zum Schreiben oder zum Löschen eines Datenelements in einem Speicher der integrierten Schaltung ist.

15. Integrierte Schaltung nach Anspruch 14, **dadurch gekennzeichnet, dass** die integrierte Schaltung bei Empfang des Befehls zum Einstellen der Spannung zum Schreiben oder zum Löschen Mittel zum Lesen in einem Speicher der integrierten Schaltung mithilfe einer Zustandsmaschine steuert, um die Schreib- oder Löschspannung einzustellen.

16. Verfahren zum Testen, ausgeführt durch einen Tester für integrierte Schaltungen auf einem Silizium-Wafer, wobei der Tester eine einzelne Eingabe-Ausgabe-Verbindung zum Testen einer integrierten Schaltung aufweist, **dadurch gekennzeichnet, dass** das Verfahren die folgenden Schritte aufweist:
- Übertragen eines Datenrahmens über die Eingabe-Ausgabe-Verbindung an den integrierten Schaltkreis, wobei der Datenrahmen eine Zeitreferenz für die in dem Datenrahmen enthaltenen Daten, ein Validierungsfeld für die Zeitreferenz und ein Datenfeld aufweist, das mindestens einen Befehl zum Testen der integrierten Schaltung aufweist, wobei die Zeitdifferenz gleich der Dauer eines Datenbits ist,
- Empfangen eines Datenrahmens über die Eingabe-Ausgabe-Verbindung, wobei die Daten des empfangenen Datenrahmens eine Dauer haben, die gleich einem ganzzahligen Vielfachen der Zeitreferenz und größer oder gleich der doppelten Dauer der Zeitreferenz ist.

17. Verfahren nach Anspruch 15, **dadurch gekennzeichnet, dass** die Daten des empfangenen Datenrahmens eine Dauer haben, die gleich einem ganzzahligen Vielfachen der doppelten Dauer der Zeitreferenz ist.

18. Verfahren, ausgeführt durch eine integrierte Schaltung, zum Testen der integrierten Schaltung, die eine einzelne Eingabe-Ausgabe-Verbindung für den Test der integrierten Schaltung aufweist, **dadurch gekennzeichnet, dass** das Verfahren die folgenden Schritte aufweist:
- Empfangen eines Datenrahmens über die Eingabe-Ausgabe-Verbindung, wobei der Datenrahmen eine Zeitreferenz für die in dem Datenrahmen enthaltenen Daten, ein Validierungsfeld für die Zeitreferenz und ein Datenfeld aufweist, das mindestens einen Befehl zum Testen der integrierten Schaltung aufweist, wobei die Zeitdifferenz gleich der Dauer eines Datenbits ist,
- Übertragen eines Datenrahmens über die Eingabe-Ausgabe-Verbindung, wobei die Daten des übertragenen Datenrahmens eine Dauer haben, die gleich einem ganzzahligen Vielfachen der doppelten Dauer der Zeitreferenz ist.

19. Verfahren nach Anspruch 18, **dadurch gekennzeichnet, dass** die Daten des empfangenen Datenrahmens eine Dauer haben, die gleich einem ganzzahligen Vielfachen der doppelten Dauer der Zeitreferenz ist.

## Claims

1. Tester for testing integrated circuits on a silicon wafer, **characterized in that** the tester has a single input output connection for testing an integrated circuit and **in that** the tester has:
- means (E71) for transferring a data frame to the integrated circuit via the input output connection, the data frame having a time reference for the data contained in the data frame, a validation field for the time reference and a data field comprising at least one test command for the integrated circuit, the time reference being equal to the duration of one bit of data,
- means (E74) for receiving a data frame via the input output connection, the data of the received data frame having a duration equal to an integer multiple of the time reference and greater than or equal to twice the duration of the time reference.

2. Tester according to Claim 1, **characterized in that** the data of the received data frame have a duration equal to an integer multiple of twice the duration of the time reference.

3. Tester according to Claim 1 or 2, **characterized in that** each item of data of the data frame transferred to the integrated circuit is represented by a high and low logic level.

4. Tester according to any one of Claims 1 to 3, **characterized in that** the data frame transferred to the integrated circuit furthermore has a value associated with the test command for the integrated circuit.

5. Tester according to any one of Claims 1 to 3, **characterized in that** the test command for the integrated circuit is a command to adjust an analogue or frequency or digital value in the integrated circuit.

6. Tester according to Claim 5, **characterized in that** the command is a command to transmit or to receive an analogue signal in a time window following the data frame and **in that** the tester has means for transmitting or for receiving the analogue signal in the time window following the data frame.

7. Tester according to Claim 5, **characterized in that** the command is a command to adjust the internal clock of the integrated circuit or a command to adjust a voltage for writing or erasing an item of data in a memory of the integrated circuit.

8. Integrated circuit, **characterized in that** it has a single input output connection for testing the integrated circuit and **in that** it has:
- means for receiving a data frame via the input output connection, the data frame having a time reference for the data contained in the data frame, a validation field for the time reference and a data field comprising at least one test command for the integrated circuit, the time reference being equal to the duration of one bit of data,
- means for transferring a data frame via the input output connection, the data of the transferred data frame having a duration equal to an integer multiple of the time reference and greater than or equal to twice the duration of the time reference.

9. Integrated circuit according to Claim 8, **characterized in that** the data of the received data frame have a duration equal to an integer multiple of twice the duration of the time reference.

10. Integrated circuit according to Claim 8 or 9, **characterized in that** the received data frame furthermore has a value associated with the test command for the integrated circuit.

11. Integrated circuit according to Claim 10, **characterized in that** the test command for the integrated circuit is a command to adjust an analogue or frequency or digital value in the integrated circuit.

12. Integrated circuit according to Claim 10, **characterized in that** the command is a command to transmit or to receive an analogue signal in a time window following the data frame and **in that** the integrated circuit has means for transmitting or for receiving the analogue signal in the time window following the data frame.

13. Integrated circuit according to Claim 10, **characterized in that** the command is a command to adjust the internal clock of the integrated circuit.

14. Integrated circuit according to Claim 10, **characterized in that** the command is a command to adjust a voltage for writing or erasing an item of data in a memory of the integrated circuit.

15. Integrated circuit according to Claim 14, **characterized in that**, upon receiving the command to adjust the write or erasure voltage, the integrated circuit commands read means in a memory of the integrated circuit using a state machine so as to adjust the write or erasure voltage.

16. Test method implemented by a tester for testing integrated circuits on a silicon wafer, the tester having a single input output connection for testing an integrated circuit, **characterized in that** the method comprises the steps of:
- transferring a data frame to the integrated circuit via the input output connection, the data frame having a time reference for the data contained in the data frame, a validation field for the time reference and a data field comprising at least one test command for the integrated circuit, the time reference being equal to the duration of one bit of data,
- receiving a data frame via the input output connection, the data of the received data frame having a duration equal to an integer multiple of the time reference and greater than or equal to twice the duration of the time reference.

17. Method according to Claim 15, **characterized in that** the data of the received data frame have a duration equal to an integer multiple of twice the duration of the time reference.

18. Method, implemented by an integrated circuit, for testing the integrated circuit having a single input output connection for testing the integrated circuit, **characterized in that** the method comprises the steps of:
- receiving a data frame via the input output connection, the data frame having a time reference for the data contained in the data frame, a validation field for the time reference and a data field comprising at least one test command for the integrated circuit, the time reference being equal to the duration of one bit of data,
- transferring a data frame via the input output connection, the data of the transferred data frame having a duration equal to an integer multiple of twice the duration of the time reference.

19. Method according to Claim 18, **characterized in that** the data of the received data frame have a duration equal to an integer multiple of twice the duration of the time reference.
